# EUROPEAN PATENT APPLICATION

(11) **EP 2 184 784 A2**
(43) Date of publication of application: **12.05.2010**
(21) Application number: 09175314.5
(22) Date of filing: 06.11.2009
(51) Int. Cl.: H01L 31/0203

(54) **Photoelectric sensor housing assembling method and photoelectric sensor**

(30) Priority: 06.11.2008 JP 2008285330
(71) Applicant: Yamatake Corporation, Tokyo 100-6419 (JP)
(72) Inventor: Suzuki, Hisashi, TOKYO 100-6419 (JP); Soeda, Kenichi, TOKYO 100-6419 (JP); Aizawa, Hideyuki, TOKYO 100-6419 (JP)
(74) Representative: Kling, Simone

(57) **Abstract**

A housing assembly method for bonding through causing a first member and a second member, which form a tightly sealed housing that contains a sensing element, to be mutually abutting. A first resin material through which a laser beam passes is used as the first member and a second resin material that absorbs the laser beam is used as the member of the second piece. With the bonding surfaces of these members abutting each other, a laser beam having a diameter that is smaller than the width of the bonding surfaces is directed towards the bonding surfaces from the member of the first piece side to weld the bonding surfaces together while leaving non-welded portions between the abutting bonding surfaces.

## Description

### Cross Reference To Related Application

This application claims the benefit under 35 U.S.C. § 119 of Japanese Patent Application No. 2008-285330, filed on November 6, 2008 and which is hereby incorporated by reference herein in its entirety.

### Field of Technology

The present invention relates to a method for assembling a housing for a photoelectric sensor for housing a photoemitting element and a photodetecting element internally thereto, and relates to such a photoelectric sensor.

### Background of the Invention

A photoelectric sensor housings house photoemitting elements and photodetecting elements therein. Typically, a housing is structured through abutting together first and second box-shaped members and forming a bond between the abutting surfaces. In this case, preferably at a tightly sealed housing is formed so as to enable the use of the photoelectric sensor in a variety of use environments. Note that the members of the first and second pieces are made out of the same or different types of resin materials, where bonding bonds together the abutting surfaces, or a two-stage molding is performed so as to cover with resin the entire periphery of the joint, or the bonding is performed using microwave welding. (See, for example, Japanese Unexamined Patent Application Publication H11-329182, which is hereby incorporated by reference herein in its entirety) Note that while this does not refer to a photoelectric sensor, there is a so-called spot welding method for localized welding of different types of synthetic resin materials using laser beams. (See, for example, Japanese Unexamined Patent Application Publication S60-214931, which is hereby incorporated by reference herein in its entirety.)

In a photoelectric sensor of this type, prior to the bonding operation, lenses that are provided facing the photoemitting element and the photodetecting element, respectively, which are housed therein, are provided in advance integrally with the members of the first and second pieces that are made out of the resins. The reason for this is that it is important that the optical distances between the lenses and the photoemitting element and the photodetecting element be established precisely when the member of the first piece and the member of the second piece are abutted together and bonded.

However, when adhering the member of the first piece and the member of the second piece, there is a problem in that there is poor manufacturability because of difficulties in handling the adhesive agent and because of the time required for the curing of the adhesive agent. Conversely, when the two-stage molding method is used to bond together the member of the first piece and the member of the second piece, there are problems with equipment costs and manufacturability due to, for example, the need for the dies for the two-stage molding and the need for a molding procedure as well. In the case of abutting together the member of the first piece and the member of the second piece and then performing ultrasonic welding, there is a tendency for the members to become misaligned due to the vibrations, or for there to be locations wherein there is inadequate welding wherein the energy directors provided on the bonding surfaces of the members remain unmelted, for example, such causing quality to be unstable at the time of mass production.

### Summary of the Invention

The present invention is the result of contemplation of the situation set forth above, and the object thereof is to provide a photoelectric sensor housing assembling method and photoelectric sensor that are well-suited to mass production when forming a photoelectric sensor housing by abutting and bonding together members of the first and second pieces made out of resin.

The present invention by which to achieve the object set forth above relates to a method for assembling a housing that is well-suited to providing a photoelectric sensor wherein bonding surfaces of members of the first and second pieces are abutted and bonded together to form a housing and wherein a photoemitting element and/or a photodetecting element are contained within the housing, and wherein a lens is provided in a position in the member of the first or second piece facing the photoemitting element and/or the photodetecting element, wherein:
< a > a first resin material through which a laser beam can pass easily is used as the structural member of at least the bonding surface of the member of the first piece and a second resin material through which the laser beam does not pass as easily as it does through the first resin material is used as a structural member for at least the bonding surface of the member of the second piece;
< b > a laser beam of a diameter that is smaller than the width of the bonding surface is directed at the bonding surfaces from the member of the first piece side with the bonding surfaces of the members of the first and second pieces in an abutting state; to
< c> weld together the bonding surfaces of the members of the first and second pieces while leaving a non-welded portion between the mutually abutting bonding surfaces.

Note that the member of the first and/or second piece has a box shape that is open on one end side, where the end face on the open side is used as the bonding surface. Additionally, preferably a material containing a carbon filler is used as the second resin material in order to increase the degree of absorption of the laser beam. Note that the member of the first or second piece may be formed integrally with a lens that is positioned facing the photoemitting element and/or the photodetecting element.

In the method as set forth above, the bonding surfaces of the members of the first and second pieces are welded together, while leaving a non-welded portion between the bonding surfaces wherein the members of the first and second pieces that form the housing are abutting each other, thus enabling the provision of a photoelectric sensei with superior manufacturability while maintaining the tightness of seal and assembly accuracy required in the housing.

### Brief Descriptions of the Drawings

FIG. 1 is a diagram illustrating an example of manufacturing a photoelectric sensor that is assembled using a housing assembling method as set forth in one example of embodiment according to the present invention.
FIG. 2 is a diagram illustrating the cross-sectional structure of the housing assembled using the housing assembling method as set forth in one example of embodiment according to the present invention.
FIG. 3 is a diagram illustrating schematically the welded portions of the member of the first piece and the member of the piece 2 that structure the housing.

A listing of reference numerals and associated elements illustrated in the drawings is provided below:
1: Photoemitting Element
2: Photodetecting Element
3: Circuit Board
5: Member of the first piece
5b: Lens
6: Member of the second piece
7: Signal Cable (Electrical Wire)
L: Laser Beam
A: Non-Welded Area
B: Welded Area

### Detailed Description of the Invention

A housing assembly method for a sensor device as set forth in a form of embodiment according to the present invention will be explained below in reference to the drawings.

The present invention is well-suited to manufacturing a sensor device such as, for example, a photoelectric sensor, wherein a housing is formed as a tightly sealed housing and a sensing element is housed within the sealed housing, and is particularly useful in achieving miniaturization of the photoelectric sensor.

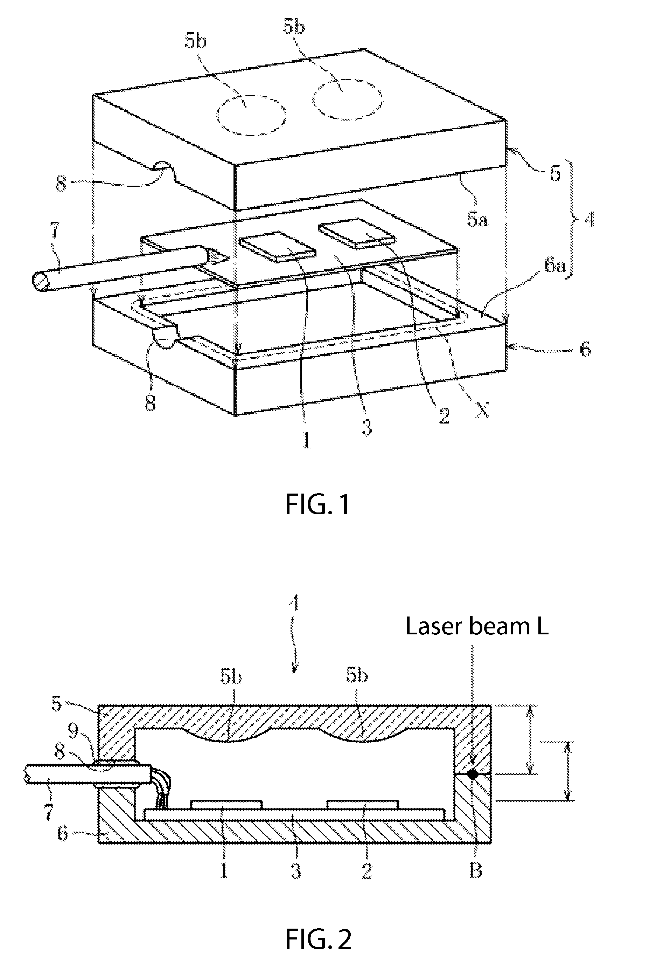

Specifically, the sensor device as set forth in a preferred embodiment is structured with a circuit board 3 upon which are mounted a photoemitting element 1 and a photodetecting element 2, as illustrated in FIG. 1, for example, housed within a sealed housing 4.

Note that the sealed housing 4 is formed by abutting together respective open end faces 5a and 6a of a member of the first piece 5 and a member of the second piece 6 that each have box shapes with one end side of each being open, each having walls that rise up around the peripheral edges of flat bottom surface portions, with the abutting surfaces being bonded airtightly to each other. In particular, the member of the first piece 5 is thereby made from a first resin material through which the laser beam passes, such as, for example, Polyacrylate (PAR), and the member of the second piece 6 is thereby made from a second resin material that absorbs the laser beam, for example, Polybutylene teraphtalate (PBT).

Note that the members of the first and second pieces 5 and 6 in the preferred embodiment may have external shapes of, for example, 10 mm in length, 5 mm in width, and 2 mm in height, where the thickness of the bottom plate portion and the wall portions is about 0.8 mm, and are formed as box-shaped injection molded products wherein is formed a hollow portion in an indentation for housing the circuit board 3 on the inside thereof. In particular, bosses (not shown) for housing the circuit board 3 by positioning in each of the directions (width, length, and depth) are provided on the inside surfaces of the member of the second piece 6. Additionally, lenses 5b and 5b are formed integrally with the member of the first piece 5. Note that these may be integrated together by adhering, to the member of the first piece 5, lenses 5b and 5b that are manufactured separately. These lenses 5b and 5b, when the open end portions 5a and 6a of the members of the first and second pieces 5 and 6, in which the circuit board 3 is housed, are abutted together, form an optics system facing the photoemitting element 1 and the photodetecting element 2 that are mounted on the circuit board 3.

In the housing assembly method for a sensor device as set forth in the present invention, the members of the first and second pieces 5 and 6 that are structured as set forth above are first caused to abut each other, and then a jig, not shown, is used to maintain this status by applying a pressure of a degree that does not cause the members of the first and second pieces 5 and 6 to deform. Next, with the open end faces 5a and 6a of the members of the first and second pieces 5 in a mutually abutting state, an infrared laser beam L of a wavelength between 800 and 1000 nm with a minute beam diameter that is focused to between 0.1 and 0.4 mm is directed at the open end faces 5a and 6a that are abutted together, from the member of the first piece 5 side, as illustrated in FIG. 2, to weld (laser weld) between the members of the first and second pieces 5 and 6 in the positions illuminated by the laser beam. In particular, by moving the position illuminated by the laser beam L along the open end faces 5a and 6a through a so-called line writing procedure, it is possible to perform a continuous seam weld around the entire periphery between the open end faces 5a and 6a. Note that the "seam welding" referred to in the present invention, of course, is sufficient insofar as the welding provides airtightness to a degree that there are no failures in the operation of the sensor device due to penetration of the surrounding moisture, etc., into the sensor device in the environment of use of the sensor device that is manufactured using this sensor device housing.

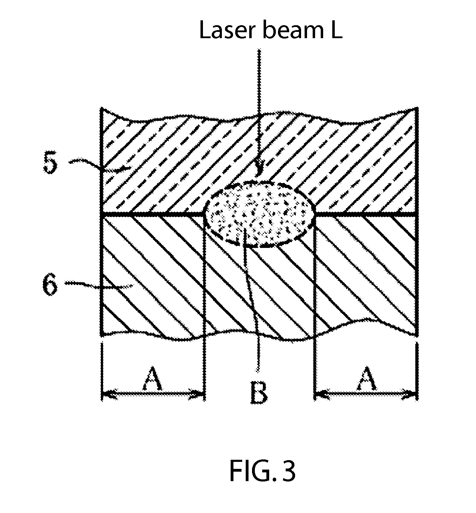

Specifically, as illustrated in FIG. 3, localized melting is performed at only those locations illuminated by the fine-diameter laser beam L, while leaving a non-welded area A between the open end faces (the abutting faces) 5a and 6a of the members of the first and second pieces 5 and 6 that are abutting each other, to weld between the members of the first and second pieces 5 and 6 thereby. The melting of the member of the second piece 6 is produced through heating through the absorption of the energy of the laser beam that has passed through the member of the first piece 5, where the melting of the member of the first piece 5 is achieved through the propagation of the heat of melting of the member of the second piece 6. By gradually moving the position illuminated by the laser beam L, the temperature of the positions no longer illuminated by the laser beam will fall, enabling the melted structural materials of the members of the first and second pieces 5 and 6 to commingle and harden, to thereby enable the welding of the members of the first and second pieces 5 and 6 to be achieved in a short time. Non-welded areas A will remain on both sides of the path of the laser beam L (the dotted line X in FIG. 1).

Note that it has been confirmed that it is possible to achieve reliable welding using only the positions illuminated by the laser beam L when a polycarbonate (PC 10) including a carbon filler is used as the structural material for the member of the second piece 6. Note that this effect is assumed to be the result of the localized increase in temperature in only the positions illuminated by the laser beam L, due to the existence of the carbon filler, where the existence of the carbon filler interferes with diffusion of heat from the position that is illuminated by the laser beam L, so that the surrounding temperature (the temperature of the regions that are not illuminated with the laser beam) does not increase greatly. Furthermore, when there is a localized increase in temperature in only the positions illuminated by the laser beam L, air bubbles may be formed by the bubbling of the melted resin. If, in this case, there is a non-welded area A, then the melted resin will not escape out from the abutting surfaces 5a and 6a, even under the pressure of the air bubbles, making it possible to maintain an excellent welded state.

Consequently, the welded areas B are formed continuously, while leaving non-welded areas A between the open end faces 5a and 6a by directing the laser beam at the open end faces 5a and 6a with the members of the first and second pieces 5 and 6 abutting each other, as set forth above, to perform the seam welding between the open end faces 5a and 6a of the members of the first and second pieces 5 and 6 in the present method, and thus non-welded areas A will remain between the open end faces 5a and 6a, so that even if pressure is applied between the members of the first and second pieces 5 and 6 to cause the open end faces 5a and 6a thereof to abut each other, there will be no shift in the positional relationship in the direction of the pressure due to the melting of the members of the first and second pieces 5 and 6. In other words, the present method makes it possible to weld together the members of the first and second pieces 5 and 6 by locally melting the members of the first and second pieces 5 and 6 while maintaining the positional relationship therebetween in the direction of abutment of the members of the first and second pieces 5 and 6. In particular, it is possible to form an airtight or watertight seal therebetween through performing a continuous seam weld around the entire periphery of the abutting surfaces.

If there were no remaining non-welded area A when melting across the entire width of the open end faces 5a and 6a, then there would be deformation, due to the pressure applied by the jig, so as to cause the melted resin to be forced out from the bonding surfaces, which could cause a shift in the positional relationship, in the direction of the pressure, between the members of the first and second pieces 5 and 6. Such a positional shift could not only have an adverse effect on the optical performance, such as shifting the position of the focal point of the lens 5b, but would also be unsightly cosmetically.

Were a laser beam that is strong enough to perform melting to be illuminated across the entire width of the open end faces 5a and 6a, then there would be bubbling due to the localized increase in temperature of the melted resin due to the high energy possessed by the laser beam. In such a case, the pressure of the air bubbles that would be generated could cause the melted resin to spatter towards the inside and the outside of the housing. This could cause the spattered melted resin to adhere to the photoemitting element 1 and the photodetecting element 2 of the circuit board that is contained within the housing, or to adhere to the lens 5b, which could interfere with optical performance. Furthermore, the spattered melted resin that has adhered could interfere with the cosmetic appearance of the product. In any case, the use of a welding method that does not leave a non-welded area A would cause an increased rate of defects in the product manufacturing process, which would increase the manufacturing cost.

Note that the present invention ultimately provides the sealing performance by the portions of the members of the first and second pieces 5 and 6 that are directly abutting each other, but the welding method using the laser beam cannot adequately seal the portion wherein the signal cables (electrical wires) 7 lead out from the circuit board 3. Because of this, it is necessary to secure the sealing performance through, for example, the use of the method disclosed in Japanese Unexamined Patent Application Publication S60-214931, described above.

Specifically, the hole 8 through which the signal cables (electrical wires) 7 pass are formed in advance in portions of the members of the first and second pieces 5 and 6 which will be bonded, and the members of the first and second pieces 5 and 6 are bonded together in a state wherein the signal cables (electrical wires) 7 for connecting the circuit board 3 are extending through the hole 8. Consequently, the production of a gap between the hole 8 and the signal cables (electrical wires) 7 is unavoidable. Given this, the gap is preferably completely covered through filling the gap between the hole 8 and the signal cables (electrical wires) 7 with a third member 9, to secure the sealing performance at this location.

Note that the table below presents the results of validation of the sealing performance when assembling the airtight housing 4 with different materials (structural materials) for the members of the first and second pieces 5 and 6. Note that in this validation, various different types of sealed housings 4, having different structural materials, assembled by seam welding the members of the first and second pieces 5 and 6 using the method set forth above, were submerged in water for 240 hours and then were removed and heated and then allowed to sit for 30 minutes, at which time a visual inspection was performed for clouding within the sealed housing 4.

**[Table 1]**

| | | Member of the first piece | | |
|---|---|---|---|---|
| | | Polycarbonate | Polyacrylate | Polymethyl methacrylate |
| Member of the second piece | PC/ABS polymer alloy | Bad (water penetration) | Okay (Slight clouding) | Okay (Slight clouding) |
| | Polybutylene teraphtalate | Okay/good (Slight clouding) | Okay/good (Slight clouding) | Good (Extremely slight clouding) |
| | Polycarbonate + carbon filler | Okay (Some clouding) | Okay (Some clouding) | Okay (Some clouding) |

In the validation experiments, it was confirmed that it is possible to achieve with ease a sealed housing 4 with superior sealing performance (watertightness) when polyacrylate (PAR) or polymethyl methacrylate (PMMA) is used as the structural material for the member of the first piece 5 and polybutylene teraphtalate (PBT) is used as the structural material for the member of the second piece 6. However, there is the need for further validation regarding, for example, the impact of differing proportions with which the carbon filler is included in the resin material.

Note that the present invention is not limited to the forms of embodiment set forth above. While the explanation was for a case of a housing for a photoelectric sensor, the present invention may be applied similarly to, for example, a housing for containing an electromagnetic proximity sensor. That is, the present invention can be applied in general to sensor devices that require accurate definitions of distances and positional relationships between sensing elements that are included in the housing and a sensing reference surface in a sensing device that uses one end face of the housing as the sensing reference surface.

Additionally, even in a sensor device that has a photoemitting portion and a photodetecting portion, for example, even when a lens corresponding to a photoemitting portion is formed in the housing but no lens is provided corresponding to the photodetecting portion, or when provided in contact with the photodetecting element, the present invention is still useful in order to accurately define the distance and positional relationship of the photoemitting portion and the lens corresponding thereto. The same is true of course when the relationship between the photoemitting portion and the photodetecting portion is reversed. In particular, the present invention is useful as a laser welding technology in the manufacturing of so-called miniature components through micromachining. The present invention can be embodied through a variety of other modifications as well insofar as these modifications do not deviate from the spirit or intend thereof.

## Claims

1. A photoelectric sensor housing assembly method wherein, when manufacturing a photoelectric sensor, a housing is formed by abutting together bonding surfaces of members of the first and second pieces wherein a photoemitting element and/or a photodetecting element are housed within the housing and wherein a lens is provided at a position on the member of the first or second piece facing the photoemitting element and/or the photodetecting element, wherein:
a first resin material through which a laser beam can pass easily is used as a structural member for at least the bonding surface of the member of the first piece, and a second resin material through which the laser beam does not pass as easily as it does through the first resin material is used for a structural member of at least the bonding surface of the member of the second piece, and when the bonding surfaces of the members of the first and second pieces are in an abutting state, a laser beam of a diameter that is smaller than a width of the bonding surfaces is directed towards the bonding surfaces from the member of the first piece side to weld between the bonding surfaces of the members of the first and second pieces while leaving a non-welded portion between the mutually abutting bonding surfaces.

2. A photoelectric sensor housing assembling method as set forth in Claim 1, wherein at least one of member of the first and/or second piece is formed in the shape of a box that is open on one end side, where the end face on an open side is used as a bonding surface.

3. A photoelectric sensor housing assembling method as set forth in Claim 1, wherein the second resin material includes a carbon filler.

4. A photoelectric sensor housing assembling method as set forth in Claim 1, wherein the bonding surfaces of the members of the first and second pieces are seam welded to each other so as to form a sealed housing from the members of the first and second pieces.

5. A photoelectric sensor housing, wherein the housing is formed by abutting together bonding surfaces of members of the first and second pieces wherein at least one of a photoemitting element or a photodetecting element is housed within the housing, and wherein a lens is provided at a position on the member of the first or second piece facing at least one photoemitting element or the photodetecting element, wherein:
at least the bonding surface of the member of the first piece is made from a first resin material through which a laser beam can pass easily, and a structural member of at least the bonding surface of the member of the second piece is made from a second resin material through which the laser beam cannot pass easily; and
the bonding surfaces of the members of the first and second pieces are welded together leaving a non-welded portion between the mutually abutting bonding surfaces.

6. A photoelectric sensor as set forth in Claim 5, wherein at least one photoemitting element or photodetecting element has an electrical wire for conducting electricity and a hole, through which the electrical wire passes, is formed in the bonding portion of the members of the first and second pieces that form the housing, wherein at least the gap between the hole and the electrical wire is completely covered by a third member.
